# EUROPEAN PATENT APPLICATION

(11) **EP 0 558 841 A1**
(43) Date of publication of application: **08.09.1993**
(21) Application number: 92301848.5
(22) Date of filing: 04.03.1992
(51) Int. Cl.: C04B 41/51, C03C 8/18, H01B 1/16

(54) **Copper ink for aluminium nitride**

(71) Applicant: CTS Corporation, Elkhart Indiana 46514 (US)
(72) Inventor: Bloom, Terry R., Elkhart, Inidiana 46540 (US)
(74) Representative: Amann, Hannes Gerhart

(57) **Abstract**

A copper conductor formulation which exhibits outstanding properties when fired upon an aluminium nitride substrate is disclosed. The conductor formulation primarily includes copper and further includes oxygen-bearing copper, lead monoxide containing glass and a screening agent. A conductor formed in accord with the invention exhibits outstanding properties including initial and aged adhesion, conductivity and solderability.

## Description

This invention relates to electrically conductive compositions in general, and specifically to thick film copper and glass containing conductives formulated for screen printing application on aluminium nitride substrates.

Modern electronic circuits are almost exclusively assembled via printed wiring substrates. These substrates eliminate the need for the "rat's nest" of wires that abound with discretely wired circuitry and improve the yield of assembled circuitry because the wiring boards improve the consistency of device interconnection. Additionally, wiring boards have encouraged miniaturisation by providing size benefit as well as signal integrity that might otherwise be compromised on higher frequency circuitry.

Wiring substrates for commercial applications are typically fabricated from a polymer material such as epoxy or polyimide which may be cast or laminated into the desired configuration. The polymer materials are desirable because of low cost and the relative ease of general processing but have drawbacks in thermal characteristics such as maximum exposure temperature, maximum operating temperature, thermal coefficient of expansion, and thermal conductivity. Polymer substrates also may suffer from poor aged performance, mechanical strength and rigidity and other factors.

Where polymer wiring substrates have proved to be ineffective in meeting the demands of an application, the electronics industry has generally relied upon either alumina, porcelain or glass, or beryllia substrates. These substrates typically have better performance in many of the areas that prevent the use of polymer substrates. However, as with most things in the real world, these substrates are not also without particular limitation. For example, beryllia is a very good thermal conductor having high mechanical strength. Unfortunately, beryllia is also very toxic if inhaled in dust form. Exposure to beryllia dust is now restricted in the work place in many countries around the world.

Aluminium nitride, only recently commercially viable, has many properties much more desirable than those heretofore known compositions. Aluminium nitride has thermal conductivity comparable to beryllia without the toxicity. Aluminium nitride has mechanical strength and chemical stability that is comparable to other ceramic substrates.

Particularly advantageous is the thermal coefficient of expansion of this material, which very closely corresponds to the thermal coefficient of expansion of silicon, allowing for the mounting of semiconductor devices that are required to endure many thermal cycles without separating from the wiring substrate. When the high thermal conductivity of the material is considered in concert with a thermal coefficient of expansion matching silicon, the application to high power semiconductor circuits in small, high reliability packages becomes apparent.

In spite of the many advantages aluminium nitride has to offer, there are again some drawbacks. Principal among the heretofore limitations of aluminium nitride is the fact that the substrate is a non-oxide substrate. The use of a non-oxide substrate limits the selection of conductive and resistive materials suitable for application to the substrate and limits the method of application. Some of the formulations previously used with alumina react too vigorously with aluminium nitride or in other cases fail to generate any chemical adhesion whatsoever. For example, in the hybrid industry most circuits are formed upon alumina substrates using a thick film screen printing process. The screen printing process is favoured where suitable over vapour deposition processes because of the lower costs of production involved.

However, the use of aluminium nitride has previously required either the use of precious metal formulations which are necessarily expensive and which are not good conductors, owing to the relatively poor intrinsic conductivity of the materials and the high price those precious metals are sold for on the open market, or the use of expensive vapour deposition processes using materials such as tungsten and molybdenum. The advantages offered by a copper-based screen printable conductive are well described in US Patent Specification No. 4,186,615, incorporated herein by reference, which discusses the application of copper to oxide-based substrates. While heretofore known formulations were not found to be suitable for use on an aluminium nitride substrate, there is a place and a need for a copper conductor formed upon aluminium nitride.

According to the present invention there is provided a conductive composition formed upon an aluminium nitride substrate, said conductive composition comprising a first metallic conductive material and a means chemically reacted with said substrate for adhering to said conductive material and to said substrate, said adhering means comprising lead or a lead-bearing compound.

Copper conductor inks fully compatible with aluminium nitride substrates and with low associated materials cost which are intrinsically very conductive are disclosed herein. These conductor inks contain lead oxide which evokes a reaction with the aluminium nitride substrate, thereby producing a chemically bound and highly adherent conductor. These copper conductors bring forth all the advantages associated with aluminium nitride substrates, owing to the high thermal conductivity and high electrical conductivity of the resultant copper conductor while retaining the low costs associated with base metal materials.

A preferred embodiment of a conductive composition according to the present invention will now be particularly described by way of example.

Copper in the preferred embodiment is derived from a mixture of pure copper and either cupric oxide or copper hydroxide. The preferred level of copper is approximately 77 parts by weight and the oxygen bearing copper should comprise approximately 15 parts by weight. Eight parts by weight are a glass frit containing lead monoxide, boric oxide and silica. These "active" agents may then be blended with approximately 14 parts by weight suitable screening agent, yielding a formulation well suited for screening onto an aluminium nitride substrate. The element is then fired in a nitrogen atmosphere to a peak temperature of 880^{o}C. yielding a well-adhered defect free conductor.

While the suitable "active" ingredient percentage levels for oxygen-bearing copper vary from approximately 8% cupric oxide and from approximately 15% copper hydroxide, these are only minimum levels and levels of 23% cupric oxide and 30% copper hydroxide do not appear significantly to adversely affect adhesion to aluminium nitride. However, as the oxygen-bearing copper content rises, solderability of resultant conductors worsens. The present preference is for levels of about 15% cupric oxide and about 25% copper hydroxide.

Glass levels are also somewhat variable, although less so than for oxygen-bearing copper. Where 25% copper hydroxide is used, levels of only 2% glass have been determined to be adequate, with levels at least to 8% performing satisfactorily. Where 15% cupric oxide is used, glass levels from 4 to 12 percent have performed satisfactorily, with 8% being preferred.

A critical component of the preferred embodiment is the glass composition. The glass used in each of the above examples was comprised by 80% by weight lead monoxide, 10% by weight boric oxide, and 10% by weight silica. Very small changes in this formulation have been found to improve the initial adhesion of the fired conductive, but only at the significant expense of aged adhesion performance. Example 1 illustrates the variability introduced by changing the glass composition.

The use of lead oxide in the present formulation, especially at these very high levels, is believed to be very novel since much literature has been directed to problems associated with the use of lead-bearing glasses in association with aluminium nitride and the resultant attempts by others to use lead-free compositions. The fact that the preferred embodiment has such outstanding characteristics serves to question the teachings of the prior art.

### EXAMPLES

In the following example, an ink was formulated from 77 parts copper, 15 parts cupric oxide, and 8 parts glass. 14 parts screening agent which included pine oil, Elvacite and CO-430 was added to provide appropriate rheology, and the formulation was screened upon an aluminium nitride substrate.
The substrate was then fired, and initial adhesion tested for some of the samples. The remaining samples were then aged in air at 150^{o}C. for 1000 hours and adhesion was tested.

| Glass Composition | | | Initial/Aged adhesion |
|---|---|---|---|
| PbO | B203 | SiO2 | |
| 85 | 7.5 | 7.5 | 7.8/3.0 |
| 84 | 5 | 11 | 7.7/1.9 |
| 84 | 11 | 5 | 7.6/2.7 |
| 80 | 10 | 10 | 7.1/4.6 |
| 76 | 15 | 9 | 6.5/3.9 |
| 76 | 9 | 15 | 5.1/2.8 |
| 70 | 12.5 | 12.5 | 5.1/1.6 |

While the foregoing details what is felt to be the preferred embodiment of the invention, it will be appreciated that other features and design alternatives obvious to one of ordinary skill in the art may be employed.

## Claims

1. A conductive composition formed upon an aluminium nitride substrate, said conductive composition comprising a first metallic conductive material and a means chemically reacted with said substrate for adhering to said conductive material and to said substrate, said adhering means comprising lead or a lead-bearing compound.

2. The conductive composition of claim 1, wherein said first metallic conductive material comprises copper.

3. The conductive composition of claim 1, wherein said adhering means comprises boron oxide, silica and lead monoxide.

4. The conductive composition of claim 2, wherein said adhering means comprises boron oxide, silica and lead monoxide.

5. A conductive composition comprising relatively pure copper, oxygen bearing copper selected from the group of cupric oxide and copper hydroxide, glass frit, said glass frit comprising lead monoxide, silicon dioxide and boron oxide, and a means for providing the appropriate rheology of said composition required by screen printing.

6. The conductive composition of claim 5 wherein said glass frit comprises approximately 80% by weight lead monoxide.

7. The conductive composition of claim 5, wherein said glass frit comprises approximately 80% by weight lead monoxide, 10% by weight boron oxide, and 10% by weight silica.

8. The conductive composition of claim 5 wherein said oxygen bearing copper is substantially within the range of 8 to 30 parts per 100 active parts by weight.
